## Europäisches Patentamt

## European Patent Office

## Office européen des brevets

(11) Veröffentlichungsnummer: **0 045 895**
**A1**

(12) **EUROPÄISCHE PATENTANMELDUNG**

(21) Anmeldenummer: 81105923.7

(22) Anmeldetag: 27.07.81

(51) Int. Cl.³: **H 05 K 3/04**
H 01 C 17/22, H 01 L 23/56
H 03 H 3/00, H 03 F 3/60

(30) Priorität: 13.08.80 DE 3030620

(43) Veröffentlichungstag der Anmeldung:
17.02.82 Patentblatt 82/7

(84) Benannte Vertragsstaaten:
DE FR GB IT

(71) Anmelder: SIEMENS AKTIENGESELLSCHAFT Berlin
und München
Postfach 22 02 61
D-8000 München 22(DE)

(72) Erfinder: Gehring, Gerhard, Dipl.-Ing.
Geschwister-Scholl-Strasse 7
D-8025 Unterhaching(DE)

(54) Anordnung zur Änderung der elektrischen Schaltungskonfiguration von integrierten Halbleiterschaltkreisen.

(57) Anordnung zur Änderung der elektrischen Schaltungskonfiguration von integrierten Halbleiterschaltkreisen, bei
der für die Einstellung und den Abgleich von Schaltkreis-
Parametern, wie beispielsweise Referenzen, Schaltschwellen, Nullfehler (Offset-Spannungen) oder Funktionsumkehr
selektiv in der Schaltungskonfiguration der integrierten
Halbleiterschaltkreise Schaltungsverbindungen (10, 11, 12)
vorgesehen sind, die ohne mechanische oder elektrische
Belastung oder Veränderung der Schaltkreis-Chips mechanisch auftrennbar sind.

FIG 1

EP 0 045 895 A1

**0045895**

SIEMENS AKTIENGESELLSCHAFT       Unser Zeichen
Berlin und München

                                 VPA   80 P 1 1 2 6 E

## Anordnung zur Änderung der elektrischen Schaltungskonfiguration von integrierten Halbleiterschaltkreisen

Die vorliegende Erfindung betrifft eine Anordnung zur Änderung der elektrischen Schaltungskonfiguration von integrierten Halbleiterschaltkreisen für die Einstellung und den Abgleich von Schaltkreis-Parametern, wie beispielsweise Referenzen, Schaltschwellen, Nullfehler (Offsetspannungen) oder Funktionsumkehr.

Schaltkreis-Parameter der vorgenannten Art sind bei fertigen Halbleiterschaltkreis-Systemen durch einen Eingriff in das System praktisch nicht mehr korrigierbar. Unter Schaltkreis-System wird dabei der die elektrischen Funktionseinheiten einer Schaltung enthaltende Halbleiterkörper mit auf diesem verlaufenden Leiterbahnen zur elektrischen Verbindung der einzelnen Funktionseinheiten untereinander so wie Anschlußelektroden für die Kontaktierung von äußeren Zuleitungen verstanden. Das Schaltkreis-System ist also der fertige integrierte Halbleiterschaltkreis ohne äußere Zuleitungen und ohne Gehäuse.

Insbesondere treten in den Bauelementen aller, insbesondere in Silicium integrierten Halbleiterschaltkreisen aufgrund von unvermeidbaren mechanischen Verspannungen piezoresistive Einflüsse auf. Die mechanischen Verspannungen treten beispielsweise bei der Montage der Schaltkreis-Systeme in ein Gehäuse auf. Auch bei integrierten Halbleiterschaltkreisen, in denen Hall-Generatoren als Sensoren mitintegriert sind, wirken sich derartige Piezoeffekte besonders stark aus, da solche integrierte Halbleiterschaltkreise relativ groß sind
und die Hall-Generatoren relativ kleine Nutzsignale
abgeben, so daß in jedem Fall Nachfolgeverstärker benötigt werden. Die Piezoeffekte führen daher in integrierten Halbleiterschaltkreisen, in denen Hall-Generatoren integriert sind, zu sehr unangenehmen Streuungen
der magnetischen Pegel. Das Problem ist umso gravierender,
als eine einwandfreie Vormessung auf dem System nicht
möglich ist, weil nachfolgende Montageschritte die
mechanischen Verspannungen ändern können.

Bisher ist dieses Problem durch eine möglichst verspannungsfreie Montage, durch eine Abdeckung der Systeme
von Halbleiterschaltkreisen mit geeigneten Stoffen, z.B.
Sylgard oder durch Selektion der Halbleiterschaltkreise
gelöst worden.

Werden jedoch derartige Halbleiterschaltkreise in anderen
Gehäusen weiterverarbeitet, um eine größere Baugruppeneinheit zu schaffen, so kann es erneut zu mechanischen
Verspannungen kommen. Ein Beispiel für eine solche Weiterverarbeitung eines integrierten Schaltkreises in ein anderes Gehäuse ist z.B. die Herstellung einer Magnetschranke
mit einem magnetfeldgesteuerten integrierten Halbleiterschaltkreis, welcher als magnetischer Sensor einen Hall-
Generator enthält.

Es ist jedoch nicht nur ein Problem, störende Einflüsse,
wie beispielsweise die vorgenannten mechanischen Verspannungen zu kompensieren, sondern es ist auch wünschenswert, bestimmte Parameter, wie beispielsweise die eingangs
genannten Referenzen, Schaltschwellen oder eine Funktionsumkehr, etwa eine Phasenumkehr ohne großen Aufwand und
insbesondere ohne Beeinflussung des Schaltkreis-Systems
selbst variabel gestalten zu können.

-3-

Der vorliegenden Erfindung liegt daher die Aufgabe zugrunde, eine einfache Möglichkeit für die Einstellung und den Abgleich von Schaltkreis-Parametern in integrierten Schaltkreisen zu schaffen.

Diese Aufgabe wird bei einer Anordnung der eingangs genannten Art erfindungsgemäß durch selektiv in der Schaltungskonfiguration der integrierten Halbleiterschaltkreise vorgesehene, außerhalb der Schaltkreis-Chips zugängliche Schaltungsverbindungen, die ohne mechanische oder elektrische Belastung oder Veränderung der Schaltkreis-Chips mechanisch auftrennbar sind, gelöst.

Ausgestaltungen des vorstehend definierten Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:

Fig. 1 einen integrierten Schaltkreis in Form eines gegengekoppelten Operationsverstärkers mit einer Möglichkeit zur selektiven Einstellung vorgegebener Gegenkopplungswerte;

Fig. 2 eine Schaltungsanordnung, in der die Funktion eines Schaltungsteils durch Auftrennen von Schaltungsverbindungen von einer Funktionsart in eine andere überführbar ist;

Fig. 3 einen integrierten Verstärker mit einer Möglichkeit zur Einstellung der Phasenlage seines Ausgangssignals;

Fig. 4 eine Ausführungsform der erfindungsgemäßen Anordnung mit einem einem Hall-Generator nachgeschalteten Differenzverstärker und einem Abgleich-Widerstandsnetzwerk;

Fig. 5 ein Schaltbild einer weiteren Ausführungsform
eines Abgleich-Widerstandsnetzwerkes;

Fig. 6 eine schematische Darstellung eines integrierten
Halbleiterschaltkreises in einem sogenannten
Mikropack-Gehäuse mit der Möglichkeit der Durchtrennung von Leiterstegen, welche vom System
des integrierten Halbleiterschaltkreises zu
äußeren Anschlußelektroden führen.

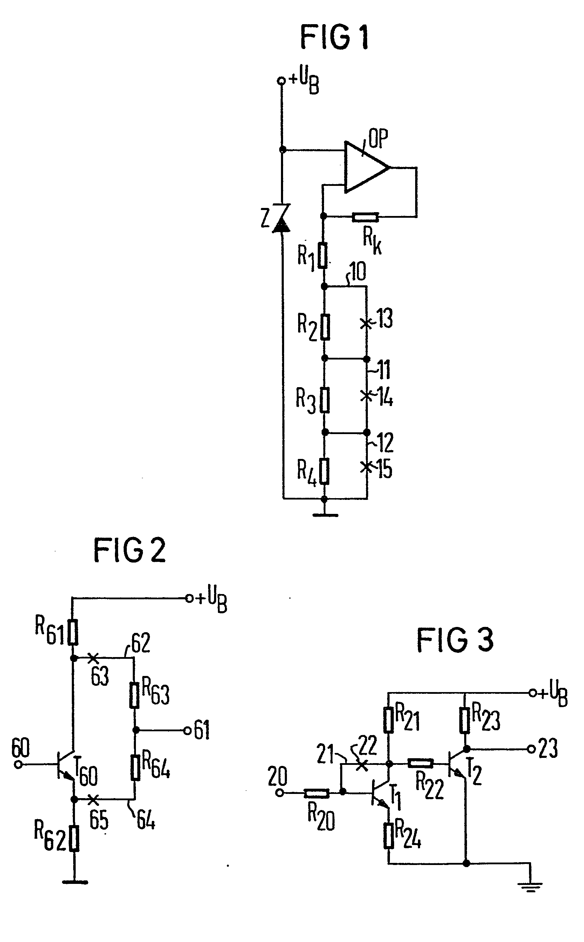

Gemäß Fig. 1 liegt ein Eingang eines Operationsverstärkers OP an einer Zener-Diode Z, an der über eine Betriebsspannung $+U_B$ ein Referenz-Potential eingestellt wird.
Ein weiterer Eingang des Operationsverstärkers OP liegt
über einem Gegenkopplungswiderstand $R_K$ am Ausgang des
Operationsverstärkers OP.

Zur selektiven Einstellung vorgegebener Gegenkopplungswerte liegt der gegengekoppelte Eingang des Operationsverstärkers OP über einem aus Widerständen $R_1$ bis $R_4$
gebildeten Spannungsteiler an Masse. Die Widerstände
$R_2$, $R_3$ und $R_4$ sind jeweils durch eine Kurzschlußüberbrückung 10, 11 bzw. 12 überbrückt. Diese Kurzschlußüberbrückungen 10 bis 12 sind bei einer integrierten
Ausführung des gegengekoppelten Operationsverstärkers
außerhalb des diesen Verstärker enthaltenden Schaltkreis-
Chips zugänglich und mechanisch auftrennbar. Diese Auftrennungen sind schematisch jeweils durch ein "X" 13,
14, bzw. 15 angedeutet. Je nachdem, in welcher Kombination die Kurzschlußüberbrückungen 10 - 12 aufgetrennt
werden, ergeben sich verschiedene Teilerverhältnisse
im Spannungsteiler $R_1$ - $R_4$, wodurch unterschiedliche
Gegenkopplungswerte einstellbar sind.

Fig. 2 zeigt eine Transistorverstärkerstufe mit einem
von einem Eingang 60 ansteuerbaren Transistor $T_{60}$, in
dessen Kollektorkreis ein mit Betriebsspannung $+U_B$ verbundener Widerstand $R_{61}$ und in dessen Emitterzweig ein

Widerstand $R_{62}$ liegt. Über Leitungsverbindungen 62 und 64 liegt zwischen Kollektor und Emitter des Transistors $T_{60}$ die Reihenschaltung zweier Widerstände $R_{63}$ und $R_{64}$. Der Verbindungspunkt der beiden Widerstände $R_{63}$ und $R_{64}$ bildet einen Ausgang 61 der Transistorverstärkerstufe.

Normalerweise arbeitet diese Transistorverstärkstufe als Gegentaktstufe. Durch Auftrennen einer der beiden Leitungsverbindungen 62 oder 64 ist diese Transistorverstärkerstufe in eine Eintaktstufe in Emitterschaltung (Auftrennen an einer Stelle 65) oder als Emitterfolger (Auftrennen an einer Stelle (63) überführbar.

Fig. 3 zeigt eine Ausführungsform eines zweistufigen Verstärkers, in dem jeweils eine Verstärkerstufe durch einen Transistor $T_1$ mit einem Arbeitswiderstand $R_{21}$ und einem Transistor $T_2$ mit einem Arbeitswiderstand $R_{23}$ gebildet wird. Aus einer Spannung $U_B$ werden über die Widerstände $R_{21}$ und $R_{23}$ die Arbeitspunkte der Verstärkerstufen eingestellt. Von einem Eingang 20 wird über einen Widerstand $R_{20}$ ein Eingangssignal in den Verstärker eingekoppelt. Im Emitterkreis liegt ein Gegenkopplungswiderstand $R_{24}$. Die erste Verstärkerstufe ist vom Kollektor des Transistors $T_1$ über einen Widerstand $R_{22}$ auf die Basis des Transistors $T_2$ der zweiten Verstärkerstufe gekoppelt. An einem Ausgang 23 ist ein Ausgangssignal des Verstärkers abnehmbar.

Zwischen dem Kollektor und der Basis des Transistors $T_1$ ist eine Kurzschlußüberbrückung 21 vorgesehen, welche bei Integration des Verstärkers außerhalb des den Verstärker enthaltenden Schaltkreis-Chips zugänglich und mechanisch auftrennbar ist. Diese Auftrennungsmöglichkeit ist schematisch durch ein "X" 22 angedeutet.

Je nachdem, ob die Kurzschlußverbindung 21 aufgetrennt
ist oder nicht, ergibt sich am Ausgang der ersten Verstärkerstufe, d.h. am Kollektor des Transistors $T_1$ ein
Phasenunterschied von $180^o$. Dieser Phasenunterschied
wird über die zweite Verstärkerstufe mit dem Transistor
$T_2$ auf den Ausgang 23 übertragen, so daß also durch
mechanische Auftrennung der Kurzschlußverbindung 21
eine Phasenumkehr am Ausgang 23 realisierbar ist.

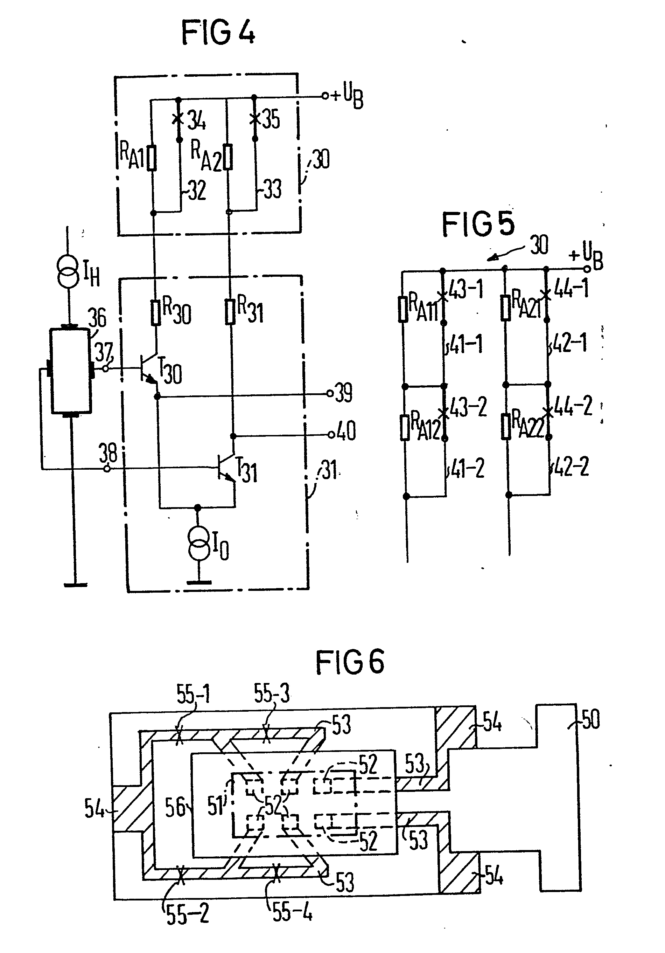

Fig. 4 zeigt eine Schaltungsanordnung mit einem Hall-
Generator 36, in dessen Steuerstromkreis aus einer
Stromquelle $I_H$ ein Steuerstrom eingespeist wird. Ein zu
erfassendes Magnetfeld kann den Hall-Generator 36 in
nicht dargestellter Weise zum Beispiel senkrecht zur
Zeichenebene durchsetzen. Da die Funktion von Hall-
Generatoren grundsätzlich bekannt ist, ist die Beschaltung
lediglich im Prinzip dargestellt. Es erübrigt sich daher,
auch, näher auf die Funktionsweise einzugehen. Die Hallstrecke des Hall-Generators 36 ist an Eingänge 37 und 38
eines Differenzverstärkers 31 angekoppelt, welcher 2 mit
ihren Emittern direkt gekoppelte Transistoren $T_{30}$ und
$T_{31}$ enthält, wobei die Emitter dieser beiden Transistoren
gemeinsam an einer Stromquelle $I_0$ liegen. In den Kollektorzweigen der Transistoren $T_{30}$ und $T_{31}$ liegen je ein
Arbeitswiderstand $R_{30}$ und $R_{31}$, wobei die Verbindungspunkte zwischen diesen beiden Widerständen und den
Kollektoren der Transistoren einen Ausgang 39, 40 des
Differenzverstärkers bilden.

In den Kollektorzweigen der Transistoren $T_{30}$ und $T_{31}$
liegt nun erfindungsgemäß ein Abgleich-Widerstandsnetzwerk 30, das durch Widerstände $R_{A1}$ und $R_{A2}$ sowie aus
Überbrückungen 32 und 33 für diese Widerstände gebildet
wird. Das Abgleich-Widerstandsnetzwerk 30 liegt weiterhin an einer Betriebsspannung $+U_B$ für den Differenzverstärker 31.

-7-

Die vorstehend beschriebene Schaltungsanordnung kann nun insgesamt in einem Halbleiterschaltkreis integriert sein, wobei dann die obengenannten Piezoeffekte aufgrund von mechanischen Verspannungen des Halbleiterschaltkreises auftreten können. Um die durch derartige mechanische Verspannungen hervorgerufenen elektrischen Störsignale bzw. Pegelverschiebungen kompensieren zu können, sind die Überbrückungen 32 und 33 für die Widerstände $R_{A1}$ und $R_{A2}$ im Abgleich-Widerstandsnetzwerk 30 selektiv auftrennbar. Dies ist schematisch durch Kreuze 34 und 35 in den Überbrückungen 32 und 33 angedeutet. Damit wird es möglich, entweder nur den Widerstand $R_{A1}$, den Widerstand $R_{A2}$ oder beide Widerstände in den Kreis des Differenzverstärkers 31 einzuschalten, um durch mechanische Verspannungen hervorgerufene elektrische Störsignale bzw. Pegelverschiebungen selektiv kompensieren zu können. Dies ist nach der Montage des die Schaltung enthaltenden Halbleitersystems möglich, wenn nach Testmessungen des Schaltkreises die den mechanischen Störungen entsprechenden elektrischen Störungen festgestellt sind. Nach einem Aufbau des Systems des Halbleiterschaltkreises in ein Gehäuse kann davon ausgegangen werden, daß keine mechanischen Belastungen mehr auf das Gehäuse und das System des Halbleiterschaltkreises ausgeübt werden.

Um eine feinere Kompensationsmöglichkeit zu schaffen, kann das Abgleich-Widerstandsnetzwerk auch komplexer aufgebaut werden. Eine solche Möglichkeit ist in Fig. 5 dargestellt. Bei dieser Ausführungsform enthält das Abgleich-Widerstandsnetzwerk 30 jeweils zwei Widerstände $R_{A11}$ und $R_{A12}$ bzw. $R_{A21}$ und $R_{A22}$ in jeweils einem Zweig mit jeweils einer Überbrückung 41-1, 41-2 bzw. 42-1, 42-2 für jeweils einen Widerstand, wobei dann vier Auftrennmöglichkeiten 43-1, 43-2 bzw. 44-1, 44-2 vorhanden sind.

Im Abgleich-Widerstandsnetzwerk können Widerstandsintervalle auch ähnlich den Schritten eines Analog-Digital-Wandlers, also beispielsweise 1 R, 2 R, 4 R, usw. gewählt werden, so daß mit drei Trennstellen 8 und mit vier Trennstellen entsprechend 16 Stufen realisierbar sind.

Fig. 6 zeigt schematisch eine Ausführungsform eines in einem sogenannten Mikropack montierten, integrierten Halbleiterschaltkreises. Zum Prinzip der Montage von Systemen integrierter Halbleiterschaltkreise in Mikropack-Bauweise wird auf Siemens Bauteile Report 16 (1978) Heft 2, Seiten 40 bis 44 hingewiesen.

In einem derartigen Mikropack wird ein Anschlußelektroden 52 aufweisendes Halbleitersystem 51 auf einen Mikropack-Film 50 aufgebracht, auf dem ein Leiterbahnmuster 53 mit Anschlußflecken 54 für den integrierten Schaltkreis vorgefertigt ist. Die Leiterbahnen 53 kontaktieren dabei die Anschlußelektroden 52 des Halbleitersystems 51. Das Halbleitersystem 51 enthält ein Abgleich-Widerstandsnetzwerk (nicht dargestellt) im Sinne der Ausführungsformen nach den vorstehend erläuterten Figuren, das über die Leiterbahnen 53 elektrisch zugänglich ist. Ein Abgleich zur Kompensation von mechanischen Verspannungen nach dem Einbau des Halbleitersystems 51 in das Mikropack kann mittels Durchtrennung bestimmter Leiterbahnen 53 im Mikropack erfolgen. Derartige Durchtrennungsmöglichkeiten sind in Fig. 6 durch Kreuze 55-1 bis 55-4 beispielsweise dargestellt. Die Durchtrennung der Leiterbahnen kann beispielsweise durch Stanzen erfolgen.

Wird ein Mikropack der vorstehend beschriebenen Art noch weiterverarbeitet, beispielsweise in ein Plastikgehäuse herkömmlicher Art eingebaut, so ist eine weitere Verbesserung der Kompensation von mechanischen Verspannungen beispielsweise auch aufgrund von Temperaturbelastungen dadurch erreichbar, daß das Halbleitersystem 51 mit einer

0045895

unmagnetischen Metallkappe 56 beispielsweise aus Aluminium oder Messing abgedeckt wird. Eine solche Kappe hat den weiteren Vorteil, daß sie eine zusätzliche Abschirmwirkung gegen elektrische Felder, z.B. bei Anwendung der Schaltkreise in der Elektronik von Kraftfahrzeugen gewährleistet.

8 Patentansprüche
6 Figuren

Patentansprüche

1. Anordnung zur Änderung der elektrischen Schaltungskonfiguration von integrierten Halbleiterschaltkreisen für die Einstellung und den Abgleich von Schaltkreis-Parametern, wie Referenzen, Schaltschwellen, Nullfehler (Offset-Spannungen) oder Funktionsumkehr, g e k e n n -z e i c h n e t   d u r c h selektiv in der Schaltungs-konfiguration der integrierten Halbleiterschaltkreise vorgesehene, außerhalb der Schaltkreis-Chips zugängliche Schaltungsverbindungen (10 bis 15; 20, 21; 32 bis 35; 41-1 bis 44-2; 55-1 bis 55-4), die ohne mechanische oder elektrische Belastung oder Veränderung der Schaltkreis-Chips mechanisch auftrennbar sind.

2. Anordnung nach Anspruch 1 für einen gegengekoppelten Operationsverstärker zur selektiven Einstellung vorge-gebener Gegenkopplungswerte, g e k e n n z e i c h n e t   d u r c h ein Spannungsteiler-Netzwerk ($R_1$ bis $R_4$) im Gegenkopplungskreis ($R_K$, $R_1$ bis $R_4$) des Operationsver-stärkers (OP), bei dem das Spannungsteilerverhältnis durch mechanisches Auftrennen von Überbrückungen (10, 11, 12) der Spannungsteiler-Widerstände ($R_1$ bis $R_4$) ver-änderbar ist.

3. Anordnung nach Anspruch 1 zur Umschaltung des Betriebsmodus einer Schaltung, beispielsweise zur Überführung einer Eintaktschaltung in eine Gegentaktschaltung oder einer Emitterschaltung in eine Kollektorschaltung oder zur Realisierung einer Phasendrehung, d a d u r c h   g e -k e n n z e i c h n e t, daß die Funktion eines Schaltungsteiles durch Auftrennen von außerhalb eines Schalt-kreis-Chips zugänglichen Schaltungsverbindungen (62 oder 63) von einer Funktionsart in eine andere Funktionsart überführbar ist.

4. Anordnung nach Anspruch 1 für einen Verstärker zur Einstellung der Phase von dessen Ausgangssignal, d a d u r c h  g e k e n n z e i c h n e t, daß in einer normalerweise phasendrehenden Stufe ($T_1$) des Verstärkers eine die Phasendrehung aufhebende Kurzschlußverbindung (20) vorgesehen ist, durch deren mechanisches Auftrennen die Phasendrehung einführbar ist.

5. Anordnung nach Anspruch 1 zur Kompensation von durch mechanische Verspannungen hervorgerufenen elektrischen Störsignalen in integrierten Halbleiterschaltkreisen, insbesondere in magnetfeldgesteuerten integrierten Halbleiterschaltkreisen, bei denen einem magneto-elektrischen Sensor, beispielsweise Hall-Generator, eine Auswerteschaltung, beispielsweise ein Verstärker nachgeschaltet ist, g e k e n n z e i c h n e t  d u r c h ein in der Auswerteschaltung (31) vorgesehenes Abgleich-Widerstandsnetzwerk (30), dessen Widerstandswerte durch mechanisches Auftrennen von Überbrückungen (32, 33; 41-1, 41-2, 42-1, 42-2; 53) von Widerständen ($R_{A1}$, $R_{A2}$; $R_{A11}$, $R_{A12}$, $R_{A21}$, $R_{A22}$) selektiv einstellbar sind.

6. Anordnung nach Anspruch 5, d a d u r c h  g e k e n n z e i c h n e t, daß das Widerstandsnetzwerk (30) im Lastkreis eines die Auswerteschaltung (31) bildenden Verstärkers vorgesehen ist.

7. Anordnung nach Anspruch 5 und/oder 6 für einen in einem Mikropack montierten integrierten Schaltkreis, d a d u r c h  g e k e n n z e i c h n e t, daß die selektive Einstellung der Widerstandswerte des Abgleich-widerstandsnetzwerkes durch Auftrennung (55-1 bis 55-4) von zu Anschlußflecken (54) des Mikropacks führenden Leiterbahnen (53) erfolgt.

8. Anordnung nach einem der Ansprüche 5 bis 7,
d a d u r c h   g e k e n n z e i c h n e t, daß das
System (51) des integrierten Schaltkreises im Mikropack mit einer nicht magnetischen Metallkappe (56)
abgedeckt ist.

## FIG 1

## FIG 2

## FIG 3

FIG 4

FIG 5

FIG 6

Europäisches Patentamt

**EUROPÄISCHER RECHERCHENBERICHT**

Nummer der Anmeldung

EP 81 10 5923.7

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | US − A − 4 182 024 (COMETTA)<br>* Spalte 2, Zeile 57 bis Spalte 3, Zeile 39; Fig. 2, 3 *<br>−− | 1,2,4 |
| | IEEE JOURNAL OF SOLID-STATE CIRCUITS, Band SC-11, Nr. 6, Dezember 1976 New York<br>J.J. PRICE "A Passive Laser-Trimming Technique to Improve the Linearity of a 10-Bit D/A Converter", Seiten 789 bis 794<br>* Seite 793, linke Spalte, letzter Absatz bis Seite 794, linke Spalte, erster Absatz; Fig. 5, 6, 7, Tabelle 1 *<br>−− | 1,2,7 |
| | US − A − 4 201 970 (ONYSHKEVYCH)<br>* Spalte 2, Zeile 9 bis Spalte 3, Zeile 2; Fig. 1, 2 *<br>−− | 1,2,7 |
| | GB − A − 1 500 394 (WELWYN ELECTRIC)<br>* Seite 3, Zeilen 84 bis 120; Fig. *<br>−− | 1-7 |
| | DE − C − 1 188 211 (TEXAS INSTRUMENTS)<br>* Spalte 3, Zeilen 5 bis 20; Fig. *<br>−− | 8 |
| | DE − B − 1 791 024 (LUCAS)<br>* Spalte 2, Zeilen 42 bis 51; Fig. 1, 2 *<br>−−−− | 8 |

**KLASSIFIKATION DER ANMELDUNG (Int. Cl.³)**

H 05 K 3/04
H 01 C 17/22
H 01 L 23/56
H 03 H 3/00
H 03 F 3/60

**RECHERCHIERTE SACHGEBIETE (Int. Cl.³)**

H 01 L 21/268
H 01 L 23/56
H 03 H 3/00
H 03 F 3/60
H 01 C 17/22
H 05 K 3/02
H 05 K 3/04
H 05 K 5/06
H 05 K 9/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 09-11-1981 | HAHN |